# EUROPEAN PATENT SPECIFICATION

(11) **EP 0 271 749 B1**
(45) Date of publication and mention of the grant of the patent: **28.07.1993**
(21) Application number: 87117453.8
(22) Date of filing: 26.11.1987
(51) Int. Cl.: H01L 21/322

(54) **Process for the manufacture of an integrated electronic device, in particular a CMOS device, with segregation of metallic impurities**
Verfahren zur Herstellung einer integrierten elektronischen Schaltung, ins besondere eines CMOS-Bauelementes, das die Absonderung metallischer Verunreinigungen umfasst
Dispositif électronique intégré, en particulier dispositif CMOS, et procédé pour sa fabrication utilisant la ségrégation d'impuretés métalliques

(30) Priority: 17.12.1986 IT 2273186
(43) Date of publication of application: 22.06.1988
(73) Proprietor: SGS-THOMSON MICROELECTRONICS s.r.l., 20041 Agrate Brianza (Milano) (IT)
(72) Inventor: Cerofolini, Gianfranco, I-20155 Milano (IT); Polignano, Maria Luisa, I-20099 Sesto San Giovanni Milano (IT)
(74) Representative: Modiano, Guido, Dr.-Ing.

(56) References cited:
- SOLID STATE TECHNOLOGY, vol. 27, no. 8, August 1984, pages 123-131, Port Washington, New York, US; J.O. BORLAND et al.: "Advanced CMOS epitaxial processing for latch-up hardening and improved epilayer quality"
- JAPANESE JOURNAL OF APPLIED PHYSICS, SUPPLEMENTS, 16th INTERNATIONAL CONFERENCE ON SOLID STATE DEVICES AND MATERIALS, 30th August - 1st September 1984, Kobe, pages 487-490, Tokyo, JP; J.O. BORLAND et al.: "Improved CMOS device performance through silicon epitaxial intrinsic gettering techniques"
- EXTENDED ABSTRACTS, vol. 86-1, no. 1, May 1986, pages 188-189, abstract no. 134, Pennington, New Jersey, US; H. WALITZKI et al.: "Control of oxygen and precipitation behaviour of heavily doped silicon substrate materials"
- EXTENDED ABSTRACTS, vol. 82-2, no. 2, October 1982, page 228, abstract no. 145, Pennington, New Jersey, US; C.W. PEARCE et al.: "Intrinsic gettering in heavily-doped silicon wafers
- IEEE ELECTRON DEVICE LETTERS, vol. EDL-4, no. 11, November 1983, pages 403-406, IEEE, New York, US; J.W. SLOTBOOM et al.: "Impact of silicon substrates on leakage currents"
- IBM TECHNICAL DISCLOSURE BULLETIN, vol. 29, no. 4, September 1986, page 1561, Armonk, New York, US; "Semiconductor wafer process contamination gettering"
- PATENT ABSTRACTS OF JAPAN, vol. 7, no. 251 (E-209)[1396], 8th November 1983; & JP-A-58 138 034

## Description

The present invention relates to a process for the manufacture of an integrated electronic device, in particular to a CMOS device, with segregation of metallic impurities.

As is known, many CMOS devices are manufactured on P/P⁺ or N/N⁺ epitaxiated substrates in order to reduce latch-up phenomena. Usually, the heavily doped region of the epitaxiated substrates (hereinafter termed bulk) is doped with boron (in the case of P/P⁺ epitaxiated substrates) or with antimony (in the case of N/N⁺ epitaxiated substrates). Also known is the use of epitaxiated wafers in order to improve diffusion current behaviour at temperatures between 50°C and 120°C in p/n junctions of integrated circuits (cf. IEEE Electron Device Letters, Vol. EDL-4, No. 11, November 1983, pp. 403-406).

It is furthermore known that MOS devices (such as for example dynamic and static RAMs, ROMs, microprocessors) as well as CMOS devices are often affected by loss currents which reduce the electric characteristics of said devices and must therefore be kept as low as possible. Said loss currents are due to different causes, including crystallographic defects or impurities which act as generation and recombination centers, increasing the generation current when they are in the emptied region and the diffusion current when they are in the neutral region (see, for example, the articles "The Role of Point-like and Extended Defects in MOS Processing", Baldi, Cerofolini, Ferla, Surface Technology, 8, 1979, pp. 161-170; "Heavy Metal Gettering in Silicon-Device Processing", Baldi, Cerofolini, Ferla, Electrochem Soc.: Solid-State Science and Technology, January 1980, pp. 164-169).

These phenomena are mostly due to the presence of metallic atoms which must therefore be removed from the active regions of the integrated devices in order to improve their performance with respect to the loss currents due to this cause.

Various so-called gettering processes, for the removal of the metallic atoms from the active regions, are known. Some of these processes are based on the property of boron and of phosphorus of capturing undesired metallic impurities, so that techniques for gettering by segregation have been developed which consist of creating regions which are heavily doped with boron or with phosphorus and of annealing at moderate temperature so that the metallic impurities are segregated in these heavily doped regions and are thus removed from the active regions of the device (the emptied regions of the junctions and of the capacitors).

According to this technique, the heavily doped regions are usually created on the back of the wafer or on the front in the contacts, by means of a predeposition or of a very heavy implant.

The technique described, though effective in the segregation of metallic impurities, with benefits for the electric behavior of the final device, is however not free from disadvantages, in particular in the case of predeposition in the contacts. In fact this solution restricts the possibility of reducing the dimensions of the integrated devices being manufactured, setting a limit to the current trend toward increasing miniaturization and increasingly dense integration of devices. Moreover, though it is always possible to perform a predeposition only on the back of the wafer, this procedure requires the execution of a greater number of manufacturing steps, especially in the case of CMOS devices, in order to prevent the phosphorus from contaminating the P⁺ contacts.

A further gettering technique is described by EP-A-133 954. This known technique is based on gettering by oxygen precipitation. To this end EP-A-133 954 teaches, starting from a N/N⁺ or a P/P⁺ substrate, a ion implant of oxygen, forming a first thin single-crystal layer, ion-implanting electrically inactive impurity to form microdefects in said first layer, forming a second thin single-crystal layer, annealing at moderate temperature for eight hours and then forming a CMOS transistor in said second thin layer. However, above gettering technique is rater lengthy and complicated.

Given this situation, the aim of the present invention is to eliminate the above described disadvantages by providing a teaching for obtaining an effective segregation of the metallic impurities in an inactive region of the devices, without affecting other parameters of the manufacturing process, in particular without limiting the dimensions of the obtainable devices.

Within the scope of this aim, a particular object of the present invention is to provide a teaching for obtaining devices with improved electric behavior by virtue of the segregation of the metallic impurities in inactive regions of the device, and such as to require process steps which are usual in the current electronics industry, without entailing the use of complex or expensive machines or procedures.

Not least object of the present invention is to provide a teaching for obtaining reliable results, indicating at the same time repeatable and controllable conditions.

Above aims and objects, as well os others which will become apparent hereinafter, are achieved by a process for segregating metallic impurities present in integrated devices as defined in the accompanying claims.

In practice the invention consists of providing the teaching that the heavily doped substrate, or bulk, of epitaxiated structures of the indicated type can be employed to achieve gettering of metallic impurities and to segregate them in said bulk, and thus consists of providing a controllable and repeatable teaching on how to obtain structures in which there is always an effective segregation of the impurities in an electrically inactive region of the integrated electronic device. The manufactured integrated electronic CMOS device comprises at least one substrate having a preset conductivity type and a preset concentration of doping atoms, and an epitaxial layer having said preset conductivity type, but a smaller concentration of doping atoms, whereat said substrate has the function of segregation of the metallic impurities.

Accordingly, the invention relates to the use of a P/P⁺ or N/N⁺ epitaxiated substrate doped with boron or respectively with phosphorus for gettering metallic impurities by segregation.

Further characteristics and advantages of the invention will become apparent from the description of the process steps for the manufacture of diodes in P/P⁺ and N/N⁺ epitaxiated substrates with gettering of metallic impurities by segregation. In particular:
figures 1a-1h illustrate the steps for manufacturing a diode in an N/N⁺ epitaxiated substrate, by means of cross sections through a silicon wafer; and
figures 2a-2h illustrate similar process steps for the manufacture of a diode in a P/P⁺ epitaxiated substrate.

Hereinafter, the process steps for the manufacture of diodes in epitaxiated substrates of the N/N⁺ or P/P⁺ type will be described, since they yield significant results for the assessment of the effects obtainable by means of the invention, it being possible to obtain CMOS devices in a similar manner, replacing the process steps typical of the manufacture of a diode with those for the manufacture of a CMOS device.

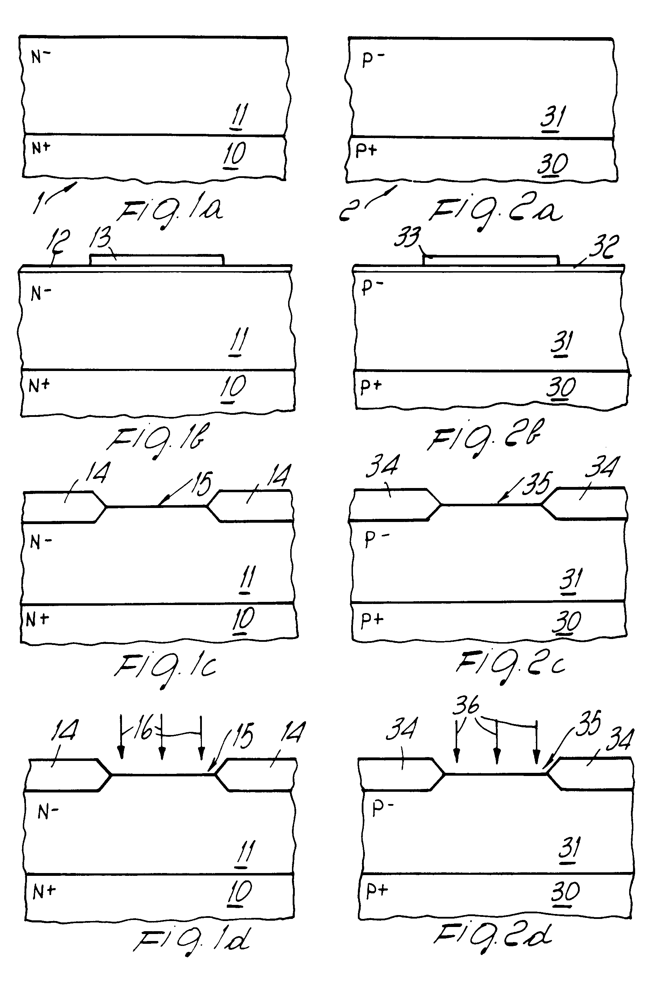

With reference to figures 1a-1h, which illustrate the process for the manufacture of a p⁺-N diode, initially (fig. 1a) a N/N⁺ type epitaxiated substrate, generally indicated at 1 comprises an N⁺ type substrate 10 doped with phosphorus at concentrations of about 10¹⁹ atoms/cm³ and an N⁻ type epitaxial layer 11 with a thickness of approximately 10 µm and a concentration of approximately 10¹⁴ -10¹⁵ atoms/cm³. A first oxidation and a deposition of silicon nitride are performed on said epitaxial substrate, followed by silicon nitride etching which leads to the obtainment of the structure illustrated in figure 1b, in which above the epitaxial layer 11 the thin oxide layer 12 and the nitride portion 13, on the region where the diode will be produced are shown. Then an ion field implant and a field oxidation are performed, with subsequent removal of the nitride layer 13 for the obtainment of the structure illustrated in figure 1c in which, above the epitaxial layer 11, portions 14 of the field oxide are shown which are mutually spaced apart so as to define a window 15 in the region where the diode will be produced. Then boron is implanted, as symbolized in figure 1d at 16 and then the region of the window 15 is oxidated, with diffusion of the boron atoms in the epitaxial layer and obtainment of a p⁺ type layer 17 as well as formation of a thin oxide layer 18 which covers the region 17 and connects the portions 14 of the field oxide, as illustrated in figure 1e.

Subsequently oxide is deposited, forming the dielectric, thus an oxide layer 19 forms above the field oxide 14 and the thin layer 18, as can be seen in figure 1f. Then, by means of a masking step, a window 20 is opened in the layers 19 and 18, reaching to the region 17, which will constitute the anode of the diode. The structure thus obtained can be seen in figure 1g, in which the window 20 for the contacts, the oxide layer 19ʹ and the thin layer 18ʹ, interrupted at the window 20 are shown. Then a reflow step is performed at a temperature of about 1000°C for a time of ca. 10 min, as well as a segregation annealing step at a temperature of about 650-950°C for one or more hours. Finally the contact masking is performed, with the obtainment of the structure illustrate in figure 1h, in which 21 indicates the contact of diode which is formed by the junction between the layer 17 and the epitaxial layer 11.

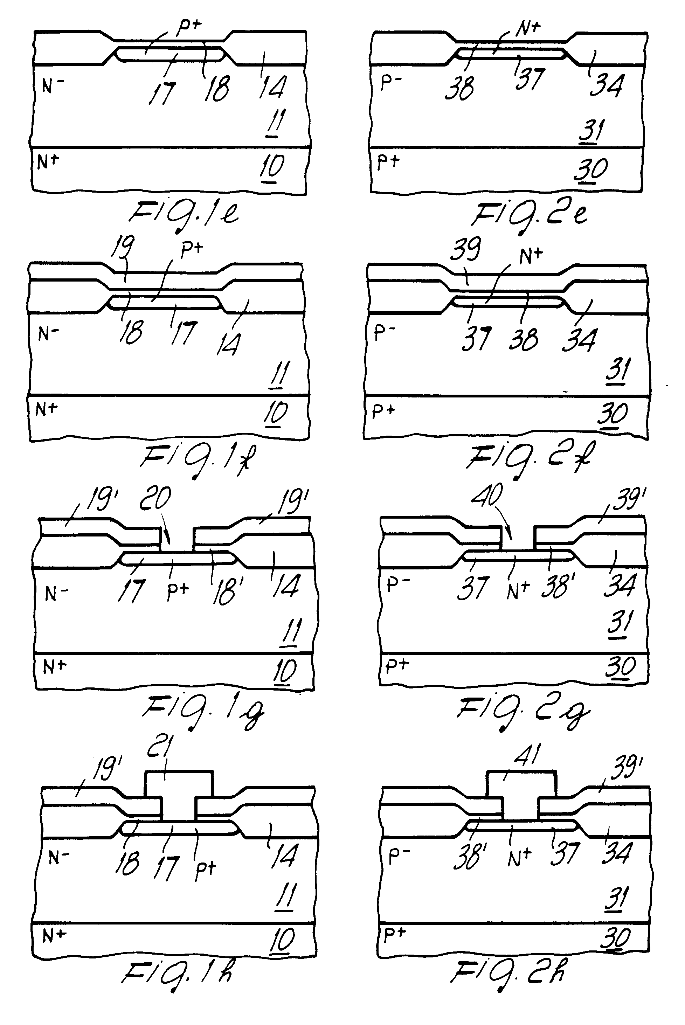

Figure 2 illustrates similar steps for the manufacture of an N⁺-P diode starting from an epitaxiated substrate 2 of the P/P⁺ type. The epitaxiated substrate 2 comprises of a substrate of bulk 30 of the P⁺ type doped with boron at concentrations of about 10¹⁹ atoms/cm³, and a p⁻ epitaxial layer having a thickness of ca. 10 µm (microns) and a concentration of approximately 10¹⁴-10¹⁵ atoms/cm³. This epitaxiated substrate, illustrated in figure 2a, then undergoes the oxidation and nitride deposition steps, leading to the obtainment of the oxide layer 32 and of the nitride layer 33, which are visible in figure 2b. Then field oxidation and removal of the nitride layer are performed, and the structure of figure 2c is obtained, in which the field oxide is indicated at 34 and delimits a window 35 above the region where the diode will be formed. Then arsenic is implanted, as symbolized in figure 2d by the arrows 36 and the region at the window 35 is oxidated at a temperature around 800-900°C , so as to form the cathode region 37 with N⁺ conductivity type, and of the thin oxide layer 38 between the two field oxide portions 34. Then dielectric is deposited, with formation of the oxide layer 39 which covers the field oxide 34 and the thin layer 38 (figure 2f) and then the structure is masked for obtaining a window 40 in the oxide layers 39 and 38 for the definition of the contact. The structure of figure 2g is thus obtained, showing the window 40 and the remaining oxide portions 39ʹ and 38ʹ. A reflow anneal step is then performed at a temperature of about 1000°C for a time of ca. 10 min. as well as a segregation annealing step at a temperature of approximately 650-950°C for one or more hours. This last step thus allows, as for the embodiment of figures 1a-1h, the metallic impurities remaining inside the bulk being segregated by virtue of the high concentration of phosphorus atoms present therein. Finally, metallization is performed for the obtainment of the contact 41 (figure 2h).

In practice, therefore, the two illustrated processes for the obtainment of P⁺-N and of N⁺-P diodes follow procedural steps which are similar to the known ones up to the metallization for the obtainment of the contacts, without however performing phosphorus or boron predeposition sets on the back of the wafer. However, by virtue of the metallic impurity gettering properties of the doping agent present in the heavily doped region of the substrate, segregation of metallic impurities present in said epitaxiated substrate occurs already during all the process steps carried out at sufficiently low temperature (and more precisely, in the above embodiment, during the first oxidation, during the oxidation for the obtainment of the thin oxide layers 18 and 38) thus obtaining a first segregation of the impurities. Subsequently, before the deposition of the contacts, a segregation annealing process is performed which thus allows the gettering of any impurities which have remained dissolved. This step, in order to be effective, must be performed at a moderate temperature (comprised between 600 and 850°C) for a few hours.

Tests executed by the Applicant on the diodes obtained according to the illustrated processes have proved an effective segregation of the metallic impurities inside the bulk layer, with results comparable with those obtainable with the predeposition of boron or of phosphorus on the back of the wafer or on the front in the contacts, without however requiring, as with the known process, additional process steps or without limiting the minimum dimensions of the device.

In practice, according to the invention, the use is proposed of P/P⁺ epitaxiated substrates doped with boron and of N/N⁺ epitaxiated substrates doped with phosphorus (instead of with antimony, as currently usually occurs) for the segregation of the metallic impurities in the heavily doped bulk region.

As can be seen from the preceding description, the invention fully achieves the intended aims. In practice, in fact, the invention clearly indicates the conditions required to knowingly and repeatably obtain the segregation of the impurities in an electrically inactive region and therefore for the manufacture of a device having optimal electric characteristics as to minimization of loss currents and to any other phenomenon related to the presence of metallic impurities in the active regions of the device or integrated circuit.

The invention proposed herein does not require the execution of process steps which are currently unusual in the electronics industry, nor the execution of further complex procedural steps with respect to current processes, on the contrary it simplifies the manufacturing procedure and eliminates the dimension limitations currently regarding the creation of heavily doped regions on the front in the contacts.

The invention thus conceived is susceptible to numerous modifications and variations, all of which are within the scope of the inventive concept. In particular, though in the illustrated embodiments reference was made to the steps for the obtainment of junctions for the definition of diodes, the invention relates to the manufacture of any device which can be manufactured according to the CMOS processes which use epitaxiated substrates.

## Claims

1. A process for segregating metallic impurities present in integrated electronic devices, in particular CMOS devices, manufactured starting from an P/P⁺ or N/N⁺ epitaxiated substrate, comprising a substrate having a preset conductivity type and a preset concentration of doping atoms and an epitaxial layer having said preset conductivity type and a smaller concentration than said preset concentration of doping atoms, said doping atoms being boron or phosphorus, characterized by
- forming metallic impurities segregation regions within said substrate;
- forming an electronic device into said epitaxial layer; and
- performing a reflow step and subsequently performing subsequent segregation annealing step at a temperature comprised between 650 and 950°C for a time comprised between one and a few hours for segregation by dopant gettering of said metallic impurities within said substrate.

2. A process according to claim 1, characterized in that said segregation annealing step is performed for a time comprised between 1 and 5 hours.

## Patentansprüche

1. Verfahren zur Absonderung metallischer Verunreinigungen, die in elektronischen Bauelementen, insbesondere CMOS-Bauelementen, vorhanden sind, die ausgehend von einem P/P⁺ oder N/N⁺ Epitaxialsubstrat hergestellt verden, wobei das Substrat einen vorgegebenen Leitfähigkeitstyp und eine vorgegebene Konzentration von dotierten Atomen aufweist und wobei eine epitaktische Schicht von dem selben Leitfähigkeitstyp eine - im Vergleich zu der vorgegebenen Konzentration - kleinere Konzentration an dotierten Atomen aufweist, wobei die dotierten Atome Bor oder Phosphor sind,
dadurch gekennzeichnet, daß
- Absonderungsregionen für metallische Verunreinigungen in dem Substrat gebildet werden;
- daß ein elektronisches Bauelement in der epitaktischen Schicht erzeugt wird; und
- daß ein Rückfluß-Schritt und nachfolgend ein Absonderungs-Ausglüh-Schritt bei einer Temperatur zwischen 650°C und 950°C für eine Zeit zwischen einer Stunde und einigen wenigen Stunden zur Absonderung der metallischen Verunreinigungen in dem Epitaxialsubstrat mittels Getterung durch die Dotierungssubstanz durchgeführt wird.

2. Verfahren gemäß Anspruch 1,
dadurch gekennzeichnet, daß der Absonderungs-Ausglüh-Schritt für eine Zeitdauer zwischen ein und fünf Stunden durchgeführt wird.

## Revendications

1. Procédé de ségrégation d'impuretés métalliques présentes dans des dispositifs électroniques intégrés, en particulier des dispositifs CMOS fabriqués en partant d'un substrat épitaxié P/P⁺ ou N/N⁺ comprenant un substrat ayant un type de conductivité predéterminé et une concentration predéterminée en atomes dopants et une couche épitaxiale ayant le type de conductivité prédéterminé et une concentration en atomes dopants inférieure à ladite concentration prédéterminée, ces atomes dopants étant du bore ou du phosphore, caractérisé par :
la formation de régions de ségrégation d'impuretés métalliques dans le substrat ;
la formation de dispositifs électroniques dans la couche épitaxiale ; et
la réalisation d'une étape de redistribution et la réalisation ultérieure d'une étape de recuit de ségrégation à une température comprise entre 650 et 950°C pendant une durée comprise entre une et quelques heures pour une ségrégation par piégeage par des dopants desdites impuretés métalliques dans le substrat.

2. Procédé selon la revendication 1, caractérisé en ce que l'étape de recuit de ségrégation est réalisée pendant une durée comprise entre 1 et 5 heures.
